# EUROPÄISCHE PATENTSCHRIFT

(11) **EP 2 880 763 B1**
(45) Veröffentlichungstag und Bekanntmachung des Hinweises auf die Patenterteilung: **08.05.2019**
(21) Anmeldenummer: 13750502.0
(22) Anmeldetag: 01.08.2013
(51) Int. Cl.: H03K 17/955

(54) **VERFAHREN ZUR STEUERUNG EINES KAPAZITIVEN EINKLEMMSCHUTZSYSTEMS UND EINKLEMMSCHUTZSYSTEM**
METHODS FOR CONTROLLING A CAPACITIVE ANTI-TRAP SYSTEM AND ANTI-TRAP SYSTEM
PROCÉDÉ DE COMMANDE D'UN SYSTÈME CAPACITIF ANTI-PINCEMENT ET SYSTÈME ANTI-PINCEMENT

(30) Priorität: 02.08.2012 DE 102012107115
(43) Veröffentlichungstag der Anmeldung: 10.06.2015
(73) Patentinhaber: Brose Fahrzeugteile GmbH & Co. Kommanditgesellschaft, Bamberg, 96052 Bamberg (DE)
(72) Erfinder: WÜRSTLEIN, Holger, 97475 Zeil am Main (DE); HERRMANN, Christian, 96450 Coburg (DE); POHL, Florian, 96237 Ebersdorf (DE)
(74) Vertreter: Maikowski & Ninnemann Patentanwälte Partnerschaft mbB
(86) Internationale Anmeldenummer: PCT/EP2013/002291
(87) Internationale Veröffentlichungsnummer: WO 2014/019695

(56) Entgegenhaltungen:
- DE-A1-102006 056 240
- DE-A1-102010 028 718
- US-A1- 2007 035 156

## Beschreibung

Die vorliegende Erfindung betrifft ein Verfahren zur Steuerung eines kapazitiven Einklemmschutzsystems nach dem Oberbegriff des Anspruchs 1 sowie ein kapazitives Einklemmschutzsystem nach dem Anspruch 4.

Bei Fahrzeugschließelementen, die zunehmend fremdkraftbetätigt, insbesondere motorisch verstellbar sind, besteht beim Schließen des jeweiligen Fahrzeugschließelements das erhebliche Risiko, dass beispielsweise ein Körperteil einer in der Nähe des Fahrzeugs stehenden Person eingeklemmt wird, was zu erheblichen Verletzungen führen kann. Aus diesem Grund wird bei an sich weithin bekannten kapazitiver Einklemmschutzsystemen an Fahrzeugen, insbesondere an Kraftfahrzeugen berührungslos durch eine sich ändernde elektrische Kapazität ein Hindernis im Verstellweg eines motorisch zu schließenden Fahrzeugschließelements detektiert und verhindert, dass ein Hindernis zwischen dem sich schließenden Fahrzeugschließelement und einer Fahrzeugstruktur im Bereich einer Karosserieöffnung, die durch das Fahrzeugschließelement in einer Schließposition verschlossen werden soll, eingeklemmt wird. Bei einem derartigen Fahrzeugschließelement kann es sich beispielsweise um eine Seitentür, eine Heckklappe, einen Kofferraumdeckel, eine Fensterscheibe oder ein Schiebedach eines Kraftfahrzeugs handeln.

Gegenüber rein taktilen Einklemmschutzsystemen bieten Einklemmschutzsysteme mit einer kapazitiven Erkennung den Vorteil, dass ein eventuelles Hindernis bereits vor dem Kontakt mit dem Fahrzeugschließelement oder bereits kurz danach festgestellt werden können, ohne dass eine bestimmte Kraft auf die Sensorik des Einklemmschutzsystems wirken muss, damit das System auslöst und die Verstellbewegung des Fahrzeugschließelements stoppt und/oder reversiert.

Bei kapazitiven Einklemmschutzsystemen, die der vorliegenden Erfindung zugrunde gelegt sind, macht man sich zunutze, dass bei einer Elektrodenanordnung des Einklemmschutzsystems bestehend aus mindestens einer Sendeelektrode und einer Empfangselektrode ein Signal an der Empfangselektrode empfangbar ist, das für das Vorliegen eines Hindernisses charakteristisch ist, wenn die Sendeelektrode mit elektrischem Wechselstrom angesteuert wird. So wird durch Ansteuerung der Sendeelektrode mit Wechselstrom ein elektrisches Feld erzeugt, das durch ein Hindernis derart beeinflusst wird, dass eine elektrische Kapazität messbar verändert wird. Diese messbare Veränderung der elektrischen Kapazität ist an der Empfangselektrode, die zu der Sendeelektrode beabstandet angeordnet ist, messbar und kann anhand eines von der Messelektrode empfangenen Signals, üblicherweise eines Spannungssignals, ausgewertet werden, um das Einklemmschutzsystem auszulösen und Einfluss auf die Verstellbewegung des Fahrzeugschließelements zu nehmen.

Bei einem vergleichsweise großflächigen Fahrzeugschließelement, wie zum Beispiel einer Heckklappe eines Kraftfahrzeugs, werden regelmäßig mehrere Elektrodenanordnungen räumlich zueinander beabstandet vorgesehen, um gerade Bereiche, in denen das Einklemmen eines Hindernisses besonders kritisch ist, gezielt zu überwachen. Auch bietet es sich im Zuge einer leichteren Montage an, einzelne Elektrodenanordnungen separat voneinander zu verbauen.

Beispielsweise in der US 2007/0035156 A1 ist ein Einklemmschutzsystem beschrieben, bei dem zwei Elektrodenanordnungen mit je einer Sendeelektrode und einer Empfangselektrode an einander gegenüberliegenden längsseitigen Schließkanten einer Fahrzeugheckklappe vorgesehen sind. Die einzelnen Elektrodenpaare definieren je einen Überwachungsbereich an einer Schließkante der Heckklappe, in dem ein Hindernis im Verstellweg der sich schließenden Heckklappe detektierbar ist. Die Ansteuerung und Auswertung der beiden Elektrodenpaare erfolgt dabei jeweils separat. Eine elektronische Auswerteeinheit des Einklemmschutzsystems der US 2007/0035156 A1 empfängt somit stets wenigstens zwei Signale, anhand derer die elektronische Auswerteeinheit auf das Vorliegen eines Hindernisses in dem einen oder in dem anderen Überwachungsbereich schließen muss.

Eine derartige separate Auswertung im Hinblick auf das Vorliegen eines Hindernisses in unterschiedlichen Überwachungsbereichen kann einerseits jedoch vergleichsweise aufwendig sein und andererseits ein kapazitives Einklemmschutzsystem vergleichsweise träge machen. So können beispielsweise bei kapazitiven Einklemmschutzsystemen, die aus Kostengründen nur einen einzigen Signalerzeuger vorsehen, mittels dem die jeweils verwendeten Sendeelektroden mit einem elektrischen Wechselstrom vorgegebener Amplitude und Frequenz angesteuert werden, an der Empfangselektrode oder den Empfangselektroden empfangene (Mess-) Signale nur zeitlich nacheinander von einer elektronischen Auswerteeinheit ausgewertet werden, um ein eventuelles Hindernis im Verstellweg des Fahrzeugschließelementes festzustellen.

Ein weiteres kapazitives Einklemmschutzsystem ist in der DE 10 2006 056 240 A1 beschrieben.

Der vorliegenden Erfindung liegt daher die Aufgabe zugrunde, ein kapazitives Einklemmschutzsystem der eingangs genannten Art weiter zu verbessern und insbesondere eine verbesserte Möglichkeit zur Auswertung bei zwei zueinander beabstandeten Sendeelektroden eines kapazitiven Einklemmschutzsystems bereitzustellen.

Diese Aufgabe wird sowohl mit einem Verfahren des Anspruchs 1 als auch mit einem kapazitiven Einklemmschutzsystem des Anspruchs 4 gelöst.

Erfindungsgemäß ist ein Verfahren zur Steuerung eines kapazitiven Einklemmschutzsystems eines Fahrzeugs vorgesehen, bei dem die beiden räumlich voneinander beabstandeten Sendeelektroden in mindestens zwei zueinander unterschiedlichen Betriebsmodi betrieben werden, wobei in einem ersten Betriebsmodus (durch die elektronische Auswerteeinheit) ausgewertet werden kann, ob in einem der Überwachungsbereiche ein Hindernis vorliegt, und in einem zweiten Betriebsmodus zusätzlich ausgewertet werden kann, in welchem der Überwachungsbereiche ein Hindernis vorliegt. Hierbei werden die beiden Sendeelektroden in dem ersten Betriebsmodus parallel und gleichzeitig über einen einzigen Signalerzeuger mit elektrischem Wechselstrom angesteuert und die beiden Sendeelektroden werden in dem zweiten Betriebsmodus
(a) von dem Signalerzeuger (5.1) zeitlich zueinander versetzt mit elektrischem Wechselstrom angesteuert oder
(b) gegenphasig angesteuert.

Das Vorsehen derartiger zweier zueinander unterschiedlicher Betriebsmodi für ein Einklemmschutzsystem bietet beispielsweise den Vorteil, dass in einem ersten Betriebsmodus mit höherer zeitlicher Auflösung und damit schlicht schneller das Auftreten eines Hindernisses detektiert werden kann, während in dem zweiten Betriebsmodus, gezielt zwar eine etwas langsamere, dafür genauere und ortsaufgelöste Detektion eines Hindernisses erfolgen kann.

Dieser wesentliche Aspekt eines erfindungsgemäßen Verfahrens dabei ohne Weiteres damit kombiniert werden, zur Steuerung eines kapazitiven Einklemmschutzsystems, wie zum Beispiel einer Heckklappe eines Kraftfahrzeugs zusätzlich vorzusehen, dass die beiden räumlich voneinander beabstandeten Sendeelektroden, die jeweils mit wenigstens einer Empfangselektrode zusammenwirken, zeitgleich mit elektrischen Wechselstrom derart angesteuert werden, dass mittels einer elektronischen Auswerteeinheit des Einklemmschutzsystems anhand eines einzigen empfangenen Signals bewertet werden kann, ob in einem von zwei durch die beiden Sendeelektroden bereitgestellten Überwachungsbereiche ein Hindernis im Verstellweg des sich schließenden Fahrzeugschließelements vorliegt.

Die Art und Weise, wie die beiden Sendeelektroden mit Wechselstrom angesteuert werden, ermöglicht hierbei, dass trotz zeitgleicher Ansteuerung beider Sendeelektroden anhand eines einzigen empfangenen Signal, vorzugsweise eines Spannungssignal, mittels einer elektronischen Auswerteeinheit und der ihr innewohnenden Auswertelogik automatisch ausgewertet werden kann, ob im Verstellweg des Fahrzeugschließelements ein Hindernis vorliegt. Bei einer solchen Ausführungsvariante kann somit anhand eines einzelnen empfangenen Signals automatisiert festgestellt werden, ob in einem von zwei zueinander räumlich separierten Überwachungsbereichen des kapazitiven Einklemmschutzsystems ein Hindernis vorliegt, so dass die Verstellbewegung des Fahrzeugschließelements gestoppt und/oder reversiert werden muss.

Im Unterschied zu dem Stand der Technik, beispielsweise der US 2007/0035156 A1, ist bei dieser Variante folglich keine Auswertung mehrerer zeitlich aufeinander folgender Signale zweier Empfangselektroden notwendig, bei der die von einem Elektrodenpaar überwachten Bereiche nacheinander abgefragt werden. Vielmehr erfolgt hier eine zeitgleiche Auswertung beider Überwachungsbereiche.

In einer als vorteilhaft erachteten Ausführungsvariante erfolgt die Ansteuerung der beiden Sendeelektroden mit elektrischem Wechselstrom zeitgleich und darüber hinaus derart, dass mittels der elektronischen Auswerteeinheit anhand eines einzigen empfangenen Signals bewertet werden kann, in welchem der Übertragungsbereiche ein Hindernis vorliegt. Es ist hier folglich nicht nur möglich, dass bestimmt wird, ob ein Hindernis in einem der beiden Überwachungsbereiche vorliegt, sondern auch zu bestimmen, in welchem der Überwachungsbereiche, und zwar ohne die Notwendigkeit zwei zeitlich zueinander versetzte Signale auszuwerten.

So ist in einer hierauf basierenden Variante zum Beispiel vorgesehen, dass die beiden Sendeelektroden zueinander phasenversetzt mit elektrischem Wechselstrom angesteuert werden. An der einzigen gemeinsamen Empfangselektrode ist somit bei freiem Verstellweg des Fahrzeugschließelements ein Spannungssignal erfassbar, das einen charakteristischen Sollwert (plus/minus einen zugelassenen Toleranzwert) aufweist. Tritt in einem der Überwachungsbereiche des Einklemmschutzsystems ein Hindernis im Verstellweg des sich bewegenden Fahrzeugschließelements auf, weicht das Signal an einer (gemeinsamen) Empfangselektrode in charakteristischer Weise von dem Sollwert ab, so dass hierüber darauf geschlossen werden kann, im Bereich welcher der Sendeelektroden ein Hindernis aufgetreten ist.

Eine besonders einfache Möglichkeit zur Beurteilung, in welchem der Überwachungsbereiche ein Hindernis vorliegt, lässt sich durch eine gegenphasige Ansteuerung der Sendeelektroden erreichen. Dabei sind die beiden Sendeelektroden vorzugsweise derart ausgebildet und angeordnet, dass durch die gegenphasige Ansteuerung ohne Vorliegen eines Hindernisses ein (an einer gemeinsamen Empfangselektrode) messbares Spannungssignal nahezu Null ist. Tritt nun im Bereich der einen oder anderen Sendeelektrode ein Hindernis auf und wird hierdurch die elektrische Kapazität verändert, gleichen sich die an der Empfangselektrode messbaren Kapazitäten nicht mehr (vollständig) aus, so dass sich aus dem Vorzeichen des über die Empfangselektrode empfangenen Spannungssignals ergibt, in welchem Überwachungsbereich ein Hindernis vorliegt. So wird sich durch ein Hindernis in einem der Überwachungsbereiche nur dort eine elektrische Kapazität verändern, wodurch das einzelne Spannungssignal an der einen Empfangselektrode nach oben oder unten von dem Sollwert bei freiem Verstellweg abweicht. Anhand der Abweichung kann somit festgestellt werden, in Bereich welcher Sendeelektrode ein Hindernis vorliegt.

In einer damit verwandten Ausführungsvariante ist vorgesehen, dass eine der beiden Sendeelektroden mit sinusförmig verlaufendem Wechselstrom angesteuert wird und die andere Sendeelektrode zeitgleich mit kosinusförmig verlaufendem Wechselstrom angesteuert wird. Auch hier kann anhand eines Spannungssignals an einer gemeinsamen Empfangselektrode für beide Sendeelektroden darauf geschlossen werden, in welchem der beiden Überwachungsbereiche und damit im Bereich welcher Sendeelektrode ein Hindernis aufgetreten ist, obwohl beide Sendeelektroden zeitgleich angesteuert werden.

In einer weiteren Ausführungsform, die alternativ oder ergänzend zu den zuvor erwähnten Ausführungsvarianten vorgesehen werden kann, ist zur Unterscheidung, in welchem der Überwachungsbereiche ein Hindernis vorliegt, bei zeitgleicher Ansteuerung beider Sendelektroden mit elektrischem Wechselstrom vorgesehen, dass durch die elektronische Auswerteeinheit ein moduliertes Trägersignal ausgewertet wird. Die beiden Sendeelektroden werden dabei beispielsweise über einen Frequenzmultiplexer oder mittels einer Quadraturamplitudenmodulation (auch IQ-Modulation genannt) angesteuert, so dass ein einzelnes empfangenes (Spannungs-)Signal Informationen sowohl über die elektrische Kapazität in dem einen Überwachungsbereich als auch über die elektrische Kapazität in dem anderen Überwachungsbereich enthält. Ein empfangenes (moduliertes) Signal enthält somit durch die Modulation mittels eines Frequenzmultiplexers und/oder einer IQ-Modulation Informationen darüber, ob die elektrische Kapazität im Bereich der einen (ersten) Sendeelektrode und einer Empfangselektrode bzw. der anderen (zweiten) Sendeelektrode und einer Empfangselektrode angestiegen ist, so dass von dem Vorliegen eines Hindernisses in dem jeweiligen zugehörigen Überwachungsbereich ausgegangen werden muss. Aufgrund einer Frequenz-, Amplituden- und/oder Phasenmodulation kann somit anhand eines über die Empfangselektrode empfangenen modulierten Trägersignals und einen dieses empfangene Trägersignal demodulierenden Demodulators in der elektronischen Auswerteeinheit nicht nur bestimmt werden, dass, sondern auch wo eine Kapazitätsänderung aufgetreten ist und folglich bestimmt werden, wo ein Hindernis detektiert wurde. Eine solche Information kann beispielsweise nicht nur zur Aktivierung des Einklemmschutzsystems genutzt werden, sondern auch zur Ausgabe einer visuellen oder akustischen Meldung über den Ort des Hindernisses.

Grundsätzlich kann selbstverständlich vorgesehen sein, dass mehr als zwei Sendeelektroden angesteuert und insbesondere mithilfe einer einzelnen gemeinsamen Empfangselektrode ausgewertet werden.

Bei einer Kombination der erfindungsgemäßen Lösung mit einer der vorstehend erläuterten Verfahrensvarianten, bei denen jeweils anhand eines einzigen empfangenen Signals mittels einer elektronischen Auswerteeinheit des Einklemmschutzsystems bewertet werden kann, ob in einem von zwei durch die beiden Sendeelektroden bereitgestellten Überwachungsbereiche ein Hindernis im Verstellweg des sich schließenden Fahrzeugschließelements vorliegt, werden beispielsweise die beiden Sendeelektroden in dem ersten Betriebsmodus gleichzeitig über einen einzigen Signalerzeuger mit elektrischem Wechselstrom angesteuert, während die beiden Sendeelektroden in dem zweiten Betriebsmodus separat voneinander mit elektrischem Wechselstrom angesteuert werden, das heißt, zeitlich alternierend bzw. zeitlich zueinander versetzt.

Hierbei kann in einer Weiterbildung auch vorgesehen sein, dass in dem zweiten Betriebsmodus beide Sendeelektroden von demselben Signalerzeuger zeitlich voneinander versetzt mit elektrischen Wechselstrom angesteuert bzw. beaufschlagt werden wie in dem ersten Betriebsmodus, um die Anzahl der elektronischen Komponenten möglichst gering zu halten.

In Anlehnung an eine bereits zuvor erläuterte Ausführungsvariante kann ferner alternativ oder ergänzend vorgesehen sein, dass die beiden Sendeelektroden in dem ersten Betriebsmodus gleichphasig und in dem zweiten Betriebsmodus gegenphasig angesteuert werden. Dabei ist die gleichphasige Ansteuerung mit elektrischem Wechselstrom dazu vorgesehen, dass ein über die Empfangselektrode empfangenes (Spannungs-) Signal aufsummiert ist. Hierdurch lassen sich etwaige Kapazitätsänderungen schneller feststellen, so dass das Einklemmschutzsystem früher auslöst. Bei der gegenphasigen Ansteuerung wiederum, findet, wie oben bereits erläutert, eine Differenzbildung statt, so dass eine Abtastung empfindlicher ist und bei einer Kapazitätsänderung durch ein Hindernis anhand des Vorzeichens des empfangenen Spannungssignal eine ortsaufgelöste Bewertung dahingehend möglich ist, in welchem Bereich des Fahrzeugschließelements ein Hindernis vorliegt.

Zwischen diesen beiden Betriebsmodi wird vorzugsweise durch mindestens einen elektronischen Schalter gewechselt. Dabei wird eine Ausführungsvariante als vorteilhaft erachtet, bei der der elektronische Schalter durch ein Schaltsignal ausgelöst wird, das bei Erkennung eines potentiellen Hindernisses im Bereich der Karosserieöffnung durch eine Hindernisdetektionseinrichtung des Fahrzeugs erzeugt wird. Eine derartige Hindernisdetektionseinrichtung erkennt beispielsweise mittels kapazitiver und/oder optoelektronischer Sensoren, ob im Bereich der Karosserieöffnung ein potentielles Hindernis vorliegt, bei dem die Gefahr besteht, dass das zu schließende Fahrzeugschließelement damit kollidiert. Die Hindernisdetektionseinrichtung schlägt somit an und erzeugt ein Schaltsignal, bevor über das Einklemmschutzsystem ein tatsächliches Hindernis im Verstellweg des Fahrzeugschließelements detektiert und ein Einklemmen verhindert wird. Damit kann das Einklemmschutzsystem beispielsweise von einem Betriebsmodus, in dem die langsamere, ortsaufgelöste Hindernisdetektion aktiviert ist, in einen Betriebsmodus schalten, in dem die schneller ansprechende und dafür nicht ortsaufgelöste Detektion einer Einklemmsituation aktiviert ist, wenn bereits über die Hindernisdetektionseinrichtung ein potentielles Hindernis im Bereich der Karosserieöffnung erkannt wird. In einer solchen Ausführungsvariante erfolgt folglich die Schaltung zwischen den beiden Betriebsmodi in Abhängigkeit davon, ob bereits vor der eigentlichen Detektion einer Einklemmsituation ein potentielles Hindernis durch die Hindernisdetektionseinrichtung erkannt wird und somit von einer erhöhten Wahrscheinlichkeit für die Kollision mit einem Hindernis bei dem sich schließenden Fahrzeugschließelement zu rechnen ist.

Die Erzeugung eines Schaltsignals zum Wechseln von einem (schneller auslösenden) Betriebsmodus in den anderen (empfindlicheren) Betriebsmodus kann hierbei zum Beispiel erfolgen, wenn ein aufsummiertes (Spannungs-) Signal, das über eine Empfangselektrode bei gleichphasiger Ansteuerung zweier Sendeelektroden erfasst wird, einen vorgegebenen Summenschwellwert übersteigt.

Teil einer Hindernisdetektionseinrichtung, über die das Umschalten in einen anderen Betreibsmodus triggerbar ist, kann dabei beispielsweise eine Kameraeinrichtung oder mindestens ein (Einpark-) Sensor am Heck eines Kraftfahrzeugs sein.

Ein weiterer Aspekt der vorliegenden Erfindung ist die Bereitstellung eines kapazitiven Einklemmschutzsystems gemäß dem Anspruch 4, das sich vorzugsweise zur Durchführung eines erfindungsgemäßen Verfahrens eignet. Ein solches kapazitives Einklemmschutzsystem umfasst dabei
- wenigstens zwei Sendeelektroden und eine Empfangselektrode, wobei durch ein Paar von Sendeelektrode und Empfangselektrode durch Ansteuerung der jeweiligen Sendeelektrode mit elektrischem Wechselstrom ein elektrisches Feld erzeugt wird, das durch ein Hindernis derart beeinflusst wird, das eine elektrische Kapazität messbar verändert wird und
- eine elektronische Auswerteeinheit, mittels der ein über die wenigstens eine Empfangselektrode empfangenes Signal dahingehend auswertbar ist, ob sich durch ein Hindernis im Verstellweg des Fahrzeugschließelements eine elektrische Kapazität geändert hat.

Die wenigstens zwei Sendeelektroden sind dabei - vorzugsweise an dem zu verstellenden Fahrzeugschließelement - räumlich zueinander beabstandet angeordnet, so dass sie mit einer (der) zugehörigen Empfangselektrode ein durch ein Hindernis beeinflussbares elektrisches Feld in zwei zueinander unterschiedlichen Überwachungsbereichen erzeugen können. Ferner ist erfindungsgemäß vorgesehen, dass die beiden räumlich voneinander beabstandeten Sendeelektroden in mindestens zwei zueinander unterschiedlichen Betriebsmodi betreibbar sind, wobei in einem ersten Betriebsmodus durch die elektronische Auswerteeinheit auswertbar ist, ob in einem der Überwachungsbereiche ein Hindernis vorliegt, und in einem zweiten Betriebsmodus durch die elektronische Auswerteeinheit zusätzlich auswertbar ist, in welchem der Überwachungsbereiche ein Hindernis vorliegt. Hierbei werden die beiden Sendeelektroden in dem ersten Betriebsmodus parallel und gleichzeitig über einen einzigen Signalerzeuger mit elektrischem Wechselstrom angesteuert und die beiden Sendeelektroden werden in dem zweiten Betriebsmodus
(a) von dem Signalerzeuger zeitlich zueinander versetzt mit elektrischem Wechselstrom angesteuert oder
(b) gegenphasig angesteuert.

Die für ein erfindungsgemäßes Verfahren angegebenen Vorteile und Merkmale gelten somit auch für ein erfindungsgemäßes kapazitives Einklemmschutzsystem und umgekehrt.

Dabei wird es grundsätzlich bevorzugt, dass die beiden Sendeelektroden an zueinander beabstandeten Schließkanten des Fahrzeugschließelements vorgesehen sind, über die das Fahrzeugschließelement in seiner Schließposition jeweils an der Fahrzeugstruktur anliegt. So sind wenigstens zwei Sendeelektroden vorzugsweise an verschiedenen Längsseite einer Kraftfahrzeug-Heckklappe angeordnet, so dass durch die elektronische Auswerteeinheit gegebenenfalls auswertbar ist, ob ein Hindernis an einem rechten oder linken Rand der Heckklappe aufgetreten ist.

In diesem Zusammenhang wird es auch bevorzugt, wenn wenigstens zwei Sendeelektroden zueinander achssymmetrisch ausgebildet sind und sich zumindest teilweise an jeweils einer der sich gegenüberliegenden Längsschließkanten des Fahrzeugschließelements entlang erstrecken.

Darüber hinaus sei darauf verwiesen, dass unter einem motorisch angetriebenen Verstellen eines Fahrzeugschließelements jedes fremdkraftbetätigte Verstellen verstanden wird, also insbesondere die Verstellung mittels eines Elektromotors, Hydraulikmotors und/oder Pneumatikmotors.

Weitere Vorteile und Merkmale der vorliegenden Erfindung werden bei der nachfolgenden Beschreibung von Ausführungsbeispiel anhand der Figuren deutlich werden.

Es zeigen:
- Fig. 1: in Teilen schematisch eine erste Ausführungsvariante eines erfindungsgemäßen Einklemmschutzsystems, bei dem zwei Sendeelektroden in zwei unterschiedlichen Betriebsmodi betreibbar sind;
- Fig. 2: in Teilen schematisch eine zweite Ausführungsvariante eines erfindungsgemäßen Einklemmschutzsystems, bei dem die zwei Sendeelektroden in mindestens zwei unterschiedlichen Betriebsmodi betreibbar sind und phasenverschoben angesteuert werden können;
- Fig. 3A-3B: ein Kraftfahrzeug, an dem ein Einklemmschutzsystem gemäß der Figur 1 oder 2 vorgesehen ist, um das Einklemmen eines Hindernisses zwischen einem Fahrzeugschließelement in Form einer Heckklappe und einer eine Karosserieöffnung berandenden Fahrzeugstruktur zu verhindern;
- Fig. 4: in Teilen schematisch eine Ausführungsform eines aus dem Stand der Technik bekannten Einklemmschutzsystems.

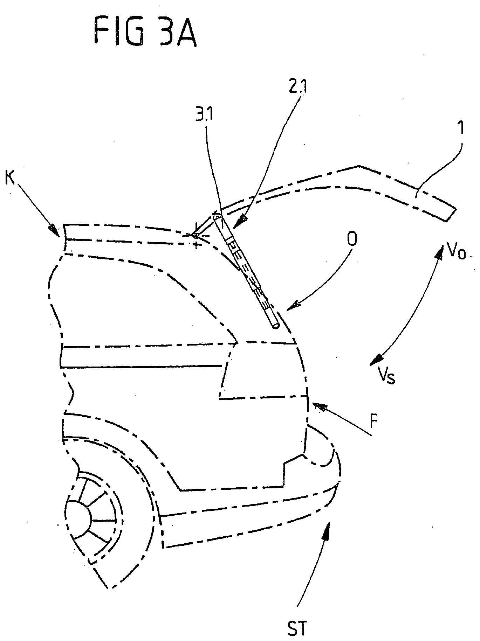

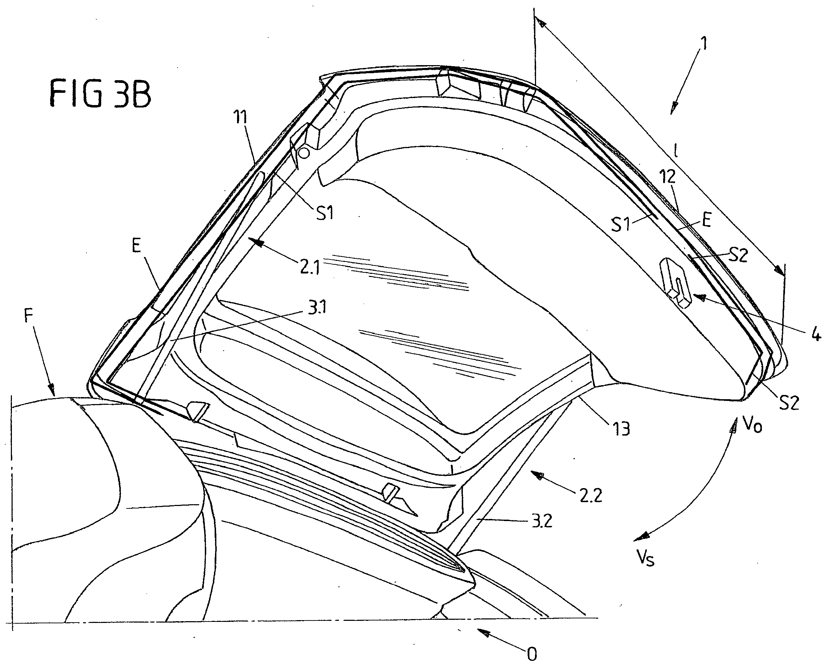

Mit den Figuren 3A und 3B ist ein Kraftfahrzeug K mit motorisch verstellbarer Heckklappe 1 dargestellt. Die Heckklappe 1 verschließt dabei in einer Schließposition, in der die Heckklappe 1 vollständig geschlossen ist, eine Karosserieöffnung O am Heck des Kraftfahrzeugs K, über die ein Laderaum des Kraftfahrzeugs K zugänglich ist. Die Heckklappe 1 ist dabei über eine Antriebseinheit 2.1, 2.2 automatisch aus einer geöffneten Position in eine Schließposition entlang einer Verstellrichtung Vs verstellbar. Vorliegend sind zur symmetrischen Verstellung der Heckklappe 1 zwei Antriebseinheiten 2.1 und 2.2 vorgesehen, die jeweils an einer Längsseite der Heckklappe also rechts oder links, an der Heckklappe 1 angreifen. Jede dieser Antriebseinheiten 2.1, 2.2 verfügt über einen Antriebsmotor 3.1, 3.2. Die beiden Antriebsmotoren 3.1, 3.2 sind hierbei über eine elektronische Steuereinrichtung steuerbar, um die Heckklappe 1 entlang der Verstellrichtung V_{S} in ihre Schließposition zu verstellen. In einer Ausführungsvariante kann zudem vorgesehen sein, dass die Antriebseinheiten 2.1, 2.2 mit ihren Antriebsmotoren 3.1, 3.2 auch dazu in der Lage sind, die an der Karosserie des Kraftfahrzeugs angelenkte Heckklappe 1 entlang einer entgegengesetzten Verstellrichtung V_{O} in eine abgeklappte und damit geöffnete Position zu verstellen.

Wesentlich ist jedoch im vorliegenden Fall, dass das Kraftfahrzeug K und insbesondere die Heckklappe 1 mit einem kapazitiven Einklemmschutzsystem ausgestattet ist, um beim Schließen der Heckklappe 1 eine Verstellbewegung der Heckklappe 1 automatisch stoppen und/oder reversieren zu können, falls zwischen einer Schließkante 11, 12, 13 der Heckklappe 1 und einer die Karosserieöffnung O berandenden Fahrzeugstruktur F ein Hindernis (nicht dargestellt) eingeklemmt würde. So besteht bei einer motorisch verschließbaren Heckklappe 1, wie auch bei anderen Fahrzeugschließelementen, zum Beispiel in Form von Fensterscheiben, Seitentüren oder Schiebedächern die Gefahr, dass insbesondere ein Körperteil einer Person eingeklemmt wird, was zu erheblichen Verletzungen führen kann. Über ein mit kapazitiver Sensorik arbeitendes Einklemmschutzsystem soll hierbei nun berührungslos ein mögliches Hindernis im Verstellweg des Fahrzeugschließelements, hier der Heckklappe 1, möglichst frühzeitig detektiert werden, um ein Einklemmen des jeweiligen Hindernisses zu verhindern. Ein solches kapazitives Einklemmschutzsystem kann dabei selbstverständlich auch durch zusätzliche Sensoren ergänzt sein, die beispielsweise das Einklemmen eines Hindernisses taktil detektieren.

Im vorliegenden Fall weist das Einklemmschutzsystem zwei längserstreckte Sendeelektroden S1, S2 auf sowie eine gemeinsame längserstreckte Empfangselektrode E. Die Empfangselektrode E erstreckt sich dabei sowohl über die beiden längsseitigen Schließkanten 11 und 13 als auch über die sie verbindende quer laufende Schleißkante 12 der Heckklappe 1, die im geschlossenen Zustand an der Fahrzeugstruktur F im Bereich eines Stoßfängers ST des Kraftfahrzeugs K anliegt und die mittig ein zur Verriegelung der Heckklappe 1 vorgesehenes Schloss 4 aufweist. Die beiden Sendeelektroden S1 und S2 verlaufen jeweils nahezu vollständig an einer der längsseitigen Schließkanten 11 bzw. 13 entlang und erstrecken sich bis etwa zur Mitte der quer verlaufenden, unteren Schließkante 12. Die beiden Sendeelektroden S1, S2 sind an der unteren Schließkante 12 nicht miteinander verbunden, sondern weisen einen Abstand zueinander auf. Die beiden Sendeelektroden S1, S2 sind somit voneinander separiert und räumlich zueinander beabstandet.

Sowohl die Sendeelektroden S1, S2 wie auch die Empfangselektrode E verlaufen an der Heckklappe 1 im Bereich ihrer Schließkanten 11, 12, 13 entlang und vorzugsweise innerhalb der Heckklappe 1, das heißt beispielsweise, unterhalb einer schützenden Kunststoffabdeckung oder einer die Elektroden umhüllenden Dichtung.

Dass sich hier die Sendeelektroden S1, S2 auch teilweise an der unteren Schließkante 12 mit dem Schloss 4 entlang erstrecken, bietet den Vorteil, dass auch ein Hindernis zwischen der unteren Schließkante 12 und einem Teil der Fahrzeugstruktur F im Bereich des Stoßfängers ST oder auch zwischen der unteren Schließkante 12 und dem Stoßfänger ST kapazitiv detektiert werden kann.

In einer alternativen Ausführungsvariante kann selbstverständlich aber auch vorgesehen sein, dass sich die Sendeelektroden S1, S2 nicht oder jeweils zumindest nicht bis zur Mitte der unteren Schließkante 12 erstrecken. Ebenso kann vorgesehen sein, dass keine durchgehenden sich über die gesamte Länge I der unteren Schließkante 12 erstreckende Empfangselektrode E vorgesehen ist. Vielmehr ist auch eine Variante denkbar, bei der zu jeder Sendeelektrode S1, S2 eine einzelne Empfangselektrode (von damit wenigstens zwei Empfangselektrode) zugehörig ist, so dass an der Heckklappe 1 zwei zueinander räumlich beabstandete Elektrodenpaare durch je eine Sendeelektrode und eine einzelne Empfangselektrode gebildet werden.

Um ein Hindernis im Verstellweg der Heckklappe 1 beim Schließen detektieren zu können, und somit ein Einklemmen des Hindernisses effektiv zu verhindern, werden die beiden Sendeelektroden S1, S2 mit elektrischem Wechselstrom angesteuert. Hierdurch wird jeweils ein elektrisches Feld erzeugt, das durch ein Hindernis derart beeinflusst wird, dass eine elektrische Kapazität messbar verändert wird. Eine Änderung der elektrischen Kapazität ist hierbei dann über die eine gemeinsame Empfangselektrode E erfassbar, so dass über eine elektronische Auswerteeinheit, die elektrisch mit der Empfangselektrode E verbunden ist, mittels einer Auswertelogik automatisch ausgewertet werden kann, ob ein Hindernis im Bereich der jeweiligen Sendeelektrode S1, S2 vorliegt.

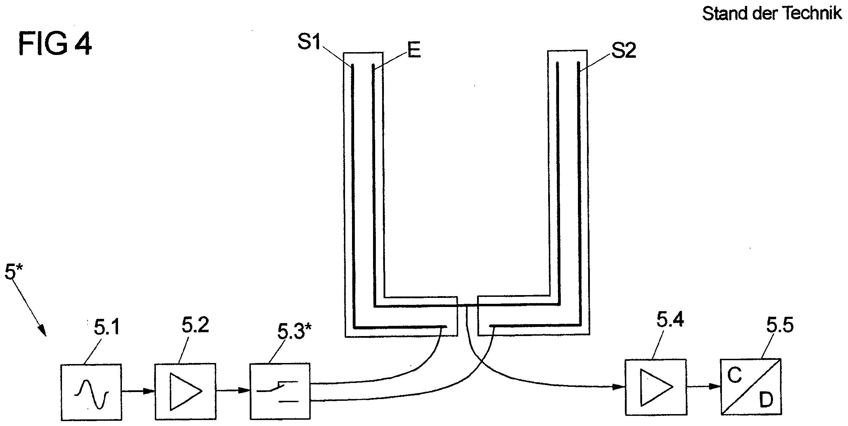

Die Figur 4 zeigt schematisch den Aufbau einer aus dem Stand der Technik bekannten elektronischen Auswerteeinheit 5*. Diese elektronische Auswerteeinheit 5* umfasst hierbei nicht nur mit der Empfangselektrode E verbundene Komponenten, wie einen Empfangsverstärker 5.4 und eine Auswerteschaltung 5.5 (mit integrierter Auswertelogik oder mit Kopplung an eine Auswertelogik), über die ein über die Empfangselektrode E empfangendes Spannungssignal verstärkt und ausgewertet werden kann, um das Auftreten eines Hindernisses im Verstellweg der Heckklappe 1 festzustellen. Vielmehr werden in der vorliegenden Ausführungsvariante auch mit den Sendeelektroden S1, S2 in Verbindung stehende Komponenten der elektronischen Auswerteeinheit 5* zugerechnet. Bei diesen mit den Sendeelektroden S1, S2 in Verbindung stehenden Komponenten, die die Ansteuerung der Sendeelektroden S1, S2 mit elektrischem Wechselstrom realisieren, handelt es sich um einen Signalerzeuger 5.1, einem diesem Signalerzeuger 5.1 nachgeschalteten Verstärker 5.2 und einen auf den Verstärker 5.2 folgenden Analogmultiplexer 5.3*.

Hierbei wird über den Signalerzeuger 5.1 Wechselstrom mit vorgegebener Amplitude und Frequenz erzeugt, der über den Verstärker 5.2 und den Analog-Multiplexer 5.3* zeitlich alternierend an die Sendeelektrode S1 oder die Sendeelektrode S2 weitergegeben wird. Über den dargestellten Aufbau mit einem Analog-Multiplexer 5.3* wird ein Wechselstrom mit vorgegebener Amplitude und Frequenz wahlweise an die (erste) Sendeelektrode S1 oder an die (zweite) Sendeelektrode S2 übertragen, so dass anhand nacheinander von der Auswerteschaltung 5.5 empfangener Signale bewertet werden kann, ob an der ersten Sendeelektrode S1 oder an der zweiten Sendeelektrode S2 eine Änderung der elektrischen Kapazität aufgetreten ist, die auf das Vorliegen eines Hindernisses im Verstellweg der Heckklappe 1 schließen lässt. Es wird also hier eine Messung mehrerer Sensorkanäle im Zeitmultiplex realisiert, um ortsaufgelöst bestimmen zu können, in welchem der durch jeweils eine Sendeelektrode S1, S2 definierten Überwachungsbereich an der Heckklappe 1 die Kollision mit einem Hindernis auftritt, wenn die Verstellbewegung der Heckklappe 1 nicht gestoppt und/oder reversiert wird.

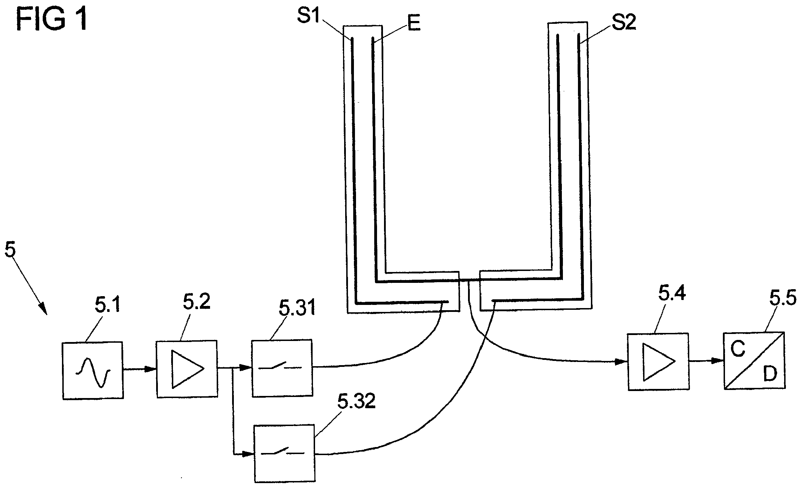

Mit der Figur 1 wird schematisch eine erste Ausführungsvariante eines erfindungsgemäßen Einklemmschutzsystems veranschaulicht, das ein erfindungsgemäßes Verfahren umsetzt.

Hierbei ist eine Auswerteeinheit 5 vorgesehen, die anstelle des Analogmultiplexers 5.3* über zwei Analogschalter 5.31 und 5.32 verfügt. Über diese Analogschalter 5.31 und 5.32 sind die beiden Sendeelektroden S1 und S2 in zwei zueinander unterschiedlichen Betriebsmodi betreibbar. Dabei werden in einem ersten Betriebsmodus die beiden Sendeelektroden S1, S2 parallel und zeitgleich über den einen Signalerzeuger 5.2 angesteuert, so dass an der einen gemeinsamen Empfangselektrode E Veränderungen der Kapazität in beiden Überwachungsbereichen, also insbesondere an der rechten und der linken Schließkante 11 und 13 der Heckklappe, feststellbar sind. Durch die Parallelschaltung der beiden Sendeelektroden S1, S2 wird somit eine vergleichsweise schnelle Detektion eines Hindernisses, z. B. mit doppelter Frequenz im Vergleich zu einem zweiten Betriebsmodus, ermöglicht, da eine etwaige Kapazitätsänderung durch ein Hindernis im Bereich der Heckklappe 1 sofort feststellbar ist und nicht erst, wenn die jeweilige Sendeelektrode S1 bzw. S2 wieder angesteuert wird, an deren zugeordneter Schließkante 11 bzw. 13 die Heckklappe 1 gegebenenfalls (maßgeblich) mit dem Hindernis kollidiert.

In dem zweiten Betriebsmodus werden die Sendeelektroden S1, S2 mittels der beiden Analogschalter 5.31 und 5.32 zeitlich alternierend angesteuert. Hierdurch erfolgt die Detektion eines Hindernisses im Vergleich zu dem ersten Betriebsmodus zwar etwas langsamer, dafür aber mit höherer Empfindlichkeit und ortsaufgelöst. Über die Auswerteschaltung 5.5 kann somit ausgewertet werden, im Überwachungsbereich welcher Sendeelektrode S1, S2 das Hindernis aufgetreten ist, das ein Stoppen und/oder ein Reversieren der Verstellbewegung der Heckklappe 1 ausgelöst hat.

Über das Vorsehen der zwei Betriebsmodi ist somit beispielsweise eine variable Anpassung an unterschiedliche Situationen möglich. Dabei kann beispielsweise vorgesehen sein, dass ein Umschalten von dem zweiten Betriebsmodus in den ersten Betriebsmodus über einen elektronischen Schalter erfolgt, wenn über eine Hindernisdetektionseinrichtung (nicht dargestellt) an dem Kraftfahrzeug K ein potentielles Hindernis im Bereich der Karosserieöffnung O festgestellt wird. Die Hindernisdetektionseinrichtung erzeugt hierbei ein Schaltsignal, das zum Umschalten in den anderen Betriebsmodus genutzt wird, wenn aufgrund eines potentiellen Hindernisses im Bereich der Karosserieöffnung O ein erhöhtes Risiko für eine tatsächliche Kollision der sich schließenden Heckklappe 1 mit einem Hindernis besteht.

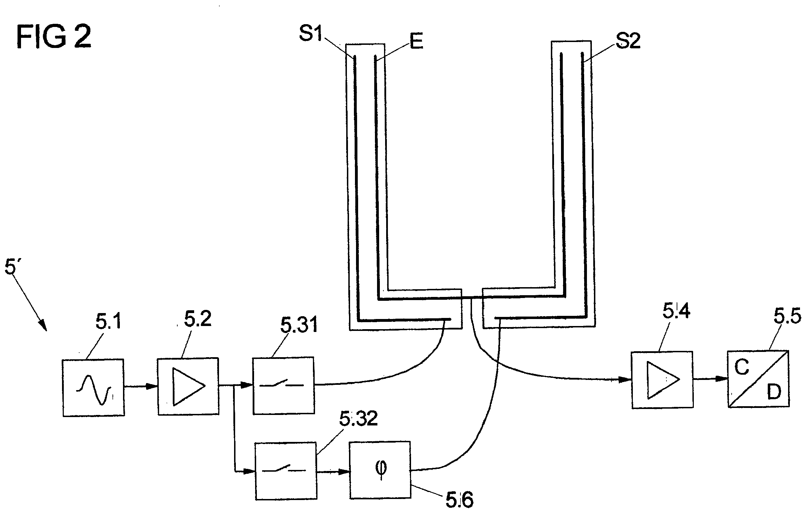

Während in der Ausführungsvariante der Figur 1 lediglich zwischen einem ersten Betriebsmodus, in dem eine Summenbildung über mehrere Sensorkanäle stattfindet, um eine schnellere Messzeit bereitzustellen, und einem zweiten Betriebsmodus, mit der Möglichkeit zur Einzelmessung bei höherer Empfindlichkeit, realisiert ist, sind bei der zweiten Ausführungsvariante der Figur 2 noch zusätzliche Mittel in Form wenigstens eines Phasenverschiebers 5.6 als Teil einer Auswerteeinheit 5' vorgesehen. Über diese Mittel wird es der Auswertelogik der Auswerteeinheit 5' ermöglicht, bereits anhand eines einzigen empfangenen Spannungssignals bewerten zu können, ob und in welchem der beiden zu je einer Sendeelektrode S1, S2 zugehörigen Überwachungsbereiche ein Hindernis vorliegt.

Dabei sind über die vorgesehenen Analogschalter 5.31 und 5.32 die beiden Sendeelektroden S1, S2 weiterhin in zwei zueinander unterschiedlichen Betriebsmodi betreibbar und ansteuerbar. In dem zweiten Betriebsmodus, in dem zusätzlich ausgewertet werden kann, in welchem der Überwachungsbereiche ein Hindernis vorliegt, müssen die beiden Sendeelektroden S1, S2 hier jedoch nicht zeitlich versetzt zueinander angesteuert werden. Vielmehr kann eine (hier die zweite) Sendeelektrode S2 durch den Phasenverschieber 5.6 parallel mit einem vorzugsweise um 180° phasenverschobenen Wechselstrom(-Signal) angesteuert werden. Werden aber die beiden Sendeelektroden S1, S2 gleichzeitig gegenphasig mit elektrischem Wechselstrom beaufschlagt, ist aufgrund der symmetrischen Ausbildung der beiden Sendeelektroden S1, S2 zueinander das an der Empfangselektrode E empfangbare Spannungssignal nahezu Null, wenn kein Hindernis vorliegt. Tritt nun aber im Bereich einer der Sendeelektroden S1, S2 ein Hindernis auf und wird hierdurch die jeweilige Kapazität verändert, überwiegt der Anteil einer der beiden Sendeelektroden S1, S2 auf das Spannungssignal. Dies hat zur Folge, dass durch die Auswerteeinheit 5' unmittelbar auswertbar ist, in welchem der Überwachungsbereiche ein Hindernis aufgetreten ist. Dies ist bei Auftreten eines Hindernisses bereits anhand des Vorzeichens eines von dem ursprünglichen (Soll-)Spannungssignal abweichenden Spannungssignal automatisch bewertbar.

Ein mit der Ausführungsvariante der Figur 2 ebenfalls möglicher erster Betriebsmodus, in dem die beiden Sendeelektroden S1, S2 zur Erhöhung der Messgeschwindigkeit parallel und gleichphasig angesteuert werden, kann hier beispielsweise durch eine einfache Deaktivierung des Phasenschiebers 5.6 realisiert werden.

Darüber hinaus ist hier selbstverständlich auch noch ein dritter Betriebsmodus möglich, bei dem der Phasenschieber 5.6 deaktiviert ist und über die beiden Analogschalter 5.31 und 5.32 in Übereinstimmung zu der Variante der Figur 1 die beiden Sendeelektroden S1, S2 zeitlich alternierend angesteuert werden. Bei Vorhandensein eines Phasenverschiebers 5.6 ist aber zur ortsaufgelösten Abtastung auf das Vorliegen eines Hindernisses die zuvor dargestellte Möglichkeit mit einer gegenphasigen Ansteuerung der beiden Sendeelektroden S1, S2 zu bevorzugen, da hierdurch auch eine Grundkapazität, die ansonsten für die Auswertung berücksichtigt werden müsste eliminiert wird. So wird die Grundkapazität durch die gegenphasige Ansteuerung der zueinander symmetrischen Sendeelektroden S1, S2 und die sich daraus ergebende Differenzbildung bei dem von der Empfangselektrode E empfangenen Spannungssignal automatisch ausgeglichen.

Auf Basis der Ausführungsvariante der Figur 2 ist ferner noch eine Weiterbildung möglich, bei der ebenfalls (in einem zweiten Betriebsmodus) eine ortsaufgelöste Detektion anhand eines einzigen über die Empfangselektrode E empfangenen und ausgewerteten Spannungssignals möglich ist. So können die beiden Sendeelektroden S1, S2 mittels eines Frequenzmultiplexers und/oder über eine Quadratamplitudenmodulation (auch IQ-Modulation genannt) gleichzeitig mit elektrischem Wechselstrom über einen einzigen Signalerzeuger 5.1 angesteuert werden. Hierdurch kann dann anhand eines über die Empfangselektrode E empfangenen modulierten Trägersignals eine ortsaufgelöste Auswertung für beide Sendeelektroden S1, S2 erfolgen. So muss hier auf der Empfängerseite und gegebenenfalls vor der Auswerteschaltung 5.6 lediglich ein Demodulator vorgesehen werden, um das empfangene Trägersignal zu demodulieren und die jeweils demodulierten Signale dahingehend auszuwerten, ob hier eine Veränderung der elektrischen Kapazität in dem jeweiligen Überwachungsbereich feststellbar ist.

In einer hierauf basierenden Ausführungsvariante kann beispielsweise vorgesehen sein, dass die beiden Sendeelektroden S1, S2 mittels orthogonaler Signale (Phasenversatz von 90°) und eines IQ-Demodulators gleichzeitig, jedoch unabhängig voneinander ausgewertet werden.

Die eigentliche Auswertung erfolgt jeweils insbesondere mithilfe der Auswerteschaltung 5.5 der Auswerteeinheit 5, 5'. Dabei werden über die Auswerteschaltung 5.5 aus einem empfangenen und gegebenenfalls demodulierten Spannungssignal ein Kapazitätssignal oder mehrere Kapazitätssignale, die jeweils für eine Sendeelektrode S1, S2 repräsentativ sind, gewonnen und das jeweilige Kapazitätssignal in ein digitales Signal konvertiert, um hierüber das Stoppen und/oder Reversieren der Verstellbewegung der Heckklappe 1 zu steuern.

### Bezugszeichenliste

- 1: Heckklappe
- 11, 12, 13: Schließkante
- 2.1, 2.2: Antriebseinheit
- 3.1, 3.2: Antriebsmotor
- 4: Schloss
- 5, 5', 5*: Auswerteeinheit
- 5.1: Signalerzeuger
- 5.2: Verstärker
- 5.3*: Analogmultiplexer
- 5.31, 5.32: Analogschalter
- 5.4: Empfangsverstärker
- 5.5: Auswerteschaltung
- 5.6: Phasenverschieber
- E: Empfangselektrode
- F: Fahrzeugstruktur
- K: Kraftfahrzeug
- I: Länge der unteren Schließkante
- O: Karosserieöffnung
- S1, S2: Sendeelektrode
- ST: Stoßfänger
- V_{S}, V_{O}: Verstellrichtung

## Patentansprüche

1. Verfahren zur Steuerung eines kapazitiven Einklemmschutzsystems eines Fahrzeugs, mittels dem ein Hindernis im Verstellweg eines fremdkraftbetätigt zu schließenden Fahrzeugschließelements detektierbar ist und mittels dem verhindert werden soll, dass ein Hindernis dem sich schließenden Fahrzeugsschließelement und einer Fahrzeugstruktur im Bereich einer Karosserieöffnung, die durch das Fahrzeugsschließelement in einer Schließposition verschlossen ist, eingeklemmt wird, wobei
- zur Detektion eines Hindernis wenigstens zwei, erste und zweite Sendeelektroden (S1, S2) und eine Empfangselektrode (E) des kapazitiven Einklemmschutzsystems verwendet sind und durch ein Paar aus erster oder zweiter Sendeelektrode (S1; S2) und Empfangselektrode (E) durch Ansteuerung der jeweiligen ersten oder zweiten Sendeelektrode (S1; S2) mit elektrischem Wechselstrom ein elektrisches Feld erzeugt wird, das durch ein Hindernis derart beeinflusst wird, dass eine elektrische Kapazität messbar verändert wird,
- eine sich ändernde elektrische Kapazität anhand eines über die Empfangselektrode (E) empfangenen Signals feststellbar ist und dieses Signal mittels einer elektronischen Auswerteeinheit (5, 5') wenigstens beim Schließen des Fahrzeugschließelements (1) ausgewertet wird, um das Vorliegen eines Hindernisses im Verstellweg des Fahrzeugschließelements (1) festzustellen, und
- die wenigstens zwei Sendelektroden (S1, S2) räumlich zueinander beabstandet sind, so dass sie mit der wenigstens einen Empfangselektrode (E) ein durch ein Hindernis beeinflussbares elektrisches Feld in zwei zueinander unterschiedlichen Überwachungsbereichen erzeugen,
**dadurch gekennzeichnet, dass** die beiden räumlich voneinander beabstandeten Sendeelektroden (S1, S2) in mindestens zwei zueinander unterschiedlichen Betriebsmodi betrieben werden, wobei in einem ersten Betriebsmodus ausgewertet wird, ob in einem der Überwachungsbereiche ein Hindernis vorliegt, und in einem zweiten Betriebsmodus zusätzlich ausgewertet wird, in welchem der Überwachungsbereiche ein Hindernis vorliegt, wobei die beiden Sendeelektroden (S1, S2) in dem ersten Betriebsmodus parallel und gleichzeitig über einen einzigen Signalerzeuger (5.1) mit elektrischem Wechselstrom angesteuert werden und die beiden Sendeelektroden (S1, S2) in dem zweiten Betriebsmodus
(a) von dem Signalerzeuger (5.1) zeitlich zueinander versetzt mit elektrischem Wechselstrom angesteuert werden oder
(b) gegenphasig angesteuert werden.

2. Verfahren Anspruch 1 **dadurch gekennzeichnet, dass** zwischen dem ersten und dem zweiten Betriebsmodus durch mindestens einen elektronischen Schalter gewechselt werden kann.

3. Verfahren nach Anspruch 2, **dadurch gekennzeichnet, dass** der elektronische Schalter durch ein Schaltsignal ausgelöst wird, das bei Erkennung eines potentiellen Hindernisses im Bereich der Karosserieöffnung (O) durch eine Hindernisdetektionseinrichtung des Fahrzeugs (K) erzeugt wird.

4. Kapazitives Einklemmschutzsystem für ein Fahrzeug, mittels dem ein Hindernis im Verstellweg eines fremdkraftbetätigt zu schließenden Fahrzeugschließelements detektierbar ist und mittels dem verhindert wird, dass ein Hindernis zwischen dem sich schließenden Fahrzeugsschließelement und einer Fahrzeugstruktur im Bereich einer Karosserieöffnung, die durch das Fahrzeugsschließelement in einer Schließposition verschlossen ist, eingeklemmt wird, wobei das Einklemmschutzsystem wenigstens das Folgende umfasst:
- wenigstens zwei, erste und zweite Sendeelektroden (S1, S2) und eine Empfangselektrode (E), wobei durch ein Paar aus erster oder zweiter Sendeelektrode (S1; S2) und Empfangselektrode (E) durch Ansteuerung der jeweiligen ersten oder zweiten Sendeelektrode (S1; S2) mit elektrischem Wechselstrom ein elektrisches Feld erzeugt wird, das durch ein Hindernis derart beeinflusst wird, dass eine elektrische Kapazität messbar verändert wird, und
- eine elektronische Auswerteeinheit (5, 5'), mittels der ein über eine Empfangselektrode (E) empfangenes Signals dahingehend auswertbar ist, ob sich durch ein Hindernis im Verstellweg des Fahrzeugschließelements (1) eine elektrische Kapazität geändert hat,
wobei die wenigstens zwei Sendelektroden (S1, S2) räumlich zueinander beabstandet sind, so dass sie mit der wenigstens einen Empfangselektrode (E) ein durch ein Hindernis beeinflussbares elektrisches Feld in zwei zueinander unterschiedlichen Überwachungsbereichen erzeugen können,
**dadurch gekennzeichnet, dass**
die beiden räumlich voneinander beabstandeten Sendeelektroden (S1, S2) in mindestens zwei zueinander unterschiedlichen Betriebsmodi betreibbar sind, wobei in einem ersten Betriebsmodus durch die elektronische Auswerteeinheit (5, 5') auswertbar ist, ob in einem der Überwachungsbereiche ein Hindernis vorliegt, und in einem zweiten Betriebsmodus durch die elektronische Auswerteeinheit (5, 5') zusätzlich auswertbar ist, in welchem der Überwachungsbereiche ein Hindernis vorliegt, wobei die beiden Sendeelektroden (S1, S2) in dem ersten Betriebsmodus parallel und gleichzeitig über einen einzigen Signalerzeuger (5.1) mit elektrischem Wechselstrom angesteuert werden und die beiden Sendeelektroden (S1, S2) in dem zweiten Betriebsmodus
(a) von dem Signalerzeuger (5.1) zeitlich zueinander versetzt mit elektrischem Wechselstrom angesteuert werden oder
(b) gegenphasig angesteuert werden.

5. Einklemmschutzsystem nach Anspruch 4, **dadurch gekennzeichnet, dass** die beiden Sendeelektroden (S1, S2) an zueinander beabstandeten Schließkanten (11, 13) des Fahrzeugschließelements (1) vorgesehen sind, über die das Fahrzeugschließelement (1) in seiner Schließposition jeweils an der Fahrzeugstruktur (F) anliegt.

## Claims

1. A method for controlling a capacitive anti-trap system of a vehicle, by means of which system an obstacle in the displacement path of a vehicle closing element to be closed, actuated by external force, is detectable, and which system is intended to prevent an obstacle from being trapped between the closing vehicle closing element and a vehicle structure in the region of a vehicle body opening which is closed by the vehicle closing element in a closed position, wherein
- at least two, first and second transmission electrodes (S1, S2) and one reception electrode (E) of the capacitive anti-trap system are used for detecting an obstacle, and an electrical field is generated by a pair comprising the first or second transmission electrode (S1; S2) and reception electrode (E) by actuation of the respective first or second transmission electrode (S1; S2) by alternating electric current, said electrical field being influenced by an obstacle such that an electrical capacitance is measurably changed,
- a changing electrical capacitance is determinable on the basis of a signal received via the reception electrode (E), and this signal is evaluated by means of an electronic evaluation unit (5, 5') at least during closing of the vehicle closing element (1) in order to determine the presence of an obstacle in the displacement path of the vehicle closing element (1), and
- the at least two transmission electrodes (S1, S2) are spaced physically apart from one another so that, with the at least one reception electrode (E), they generate an electrical field which can be influenced by an obstacle in two different monitoring regions,
**characterized in that** the two transmission electrodes (S1, S2) which are spaced physically apart from one another are operated in at least two different operating modes, wherein, in a first operating mode, it is evaluated whether an obstacle is present in one of the monitoring regions and, in a second operating mode, it is additionally evaluated in which of the monitoring regions an obstacle is present, wherein in the first operating mode, the two transmission electrodes (S1, S2) are actuated parallel and simultaneously by alternating electric current via a single signal generator (5.1) and, in the second operating mode, the two transmission electrodes (S1, S2)
(a) are actuated by alternating electric current by means of the signal generator (5.1) with a temporal offset with respect to one another or
(b) are actuated in phase opposition.

2. The method as claimed in claim 1, **characterized in that** changeover between the first and second operating modes can be effected by means of at least one electronic switch.

3. The method as claimed in claim 2, **characterized in that** the electronic switch is triggered by a switching signal which is generated by an obstacle detection device of the vehicle (K) on identification of a potential obstacle in the region of the vehicle body opening (O).

4. A capacitive anti-trap system for a vehicle, by means of which system an obstacle in the displacement path of a vehicle closing element to be closed, actuated by external force, is detectable and which system is used to prevent an obstacle from being trapped between the closing vehicle closing element and a vehicle structure in the region of a vehicle body opening which is closed by the vehicle closing element in a closed position, wherein the anti-trap system comprises at least the following:
- at least two, first and second transmission electrodes (S1, S2) and one reception electrode (E), wherein an electrical field is generated by a pair comprising the first or second transmission electrode (S1; S2) and reception electrode (E) by actuation of the respective the first or second transmission electrode (S1; S2) by alternating electric current, said electrical field being influenced by an obstacle such that an electrical capacitance is measurably changed, and
- an electronic evaluation unit (5, 5'), by means of which a signal received via a reception electrode (E) can be evaluated to ascertain whether an electrical capacitance has changed as a result of an obstacle in the displacement path of the vehicle closing element (1),
wherein the at least two transmission electrodes (S1, S2) are spaced physically apart from one another so that, with the at least one reception electrode (E), they can generate an electrical field which can be influenced by an obstacle in two different monitoring regions,
**characterized in that**
the two transmission electrodes (S1, S2) which are spaced physically apart from one another can be operated in at least two different operating modes, wherein, in a first operating mode, it is possible to evaluate, by means of the electronic evaluation unit (5, 5'), whether an obstacle is present in one of the monitoring regions and, in a second operating mode, it is additionally possible to evaluate, by means of the electronic evaluation unit (5, 5'), in which of the monitoring regions an obstacle is present, wherein in the first operating mode, the two transmission electrodes (S1, S2) are actuated parallel and simultaneously by alternating electric current via a single signal generator (5.1) and, in the second operating mode, the two transmission electrodes (S1, S2)
(a) are actuated by alternating electric current by means of the signal generator (5.1) with a temporal offset with respect to one another or
(b) are actuated in phase opposition.

5. The anti-trap system as claimed in claim 4, **characterized in that** the two transmission electrodes (S1, S2) are provided on closing edges (11, 13) of the vehicle closing element (1) which are spaced apart from one another and via each of which the vehicle closing element (1) bears against the vehicle structure (F) in the closed position of said vehicle closing element.

## Revendications

1. Procédé de commande d'un système capacitif anti-pincement d'un véhicule, au moyen duquel un obstacle est détectable dans le trajet de déplacement d'un élément de fermeture de véhicule à fermer actionné par une force extérieure et au moyen duquel il doit être évité qu'un obstacle à l'élément de fermeture de véhicule se fermant et à une structure de véhicule soit pincé dans la zone d'une ouverture de carrosserie, qui est fermée par l'élément de fermeture de véhicule dans une position de fermeture, dans lequel
- pour la détection d'un obstacle, au moins deux première et seconde électrodes d'émission (S1, S2) et une électrode de réception (E) du système capacitif anti-pincement sont utilisées et un champ électrique, qui est influencé par un obstacle de telle sorte qu'une capacité électrique est modifiée de façon mesurable, est généré par une paire formée de la première ou seconde électrode d'émission (S1 ; S2) et de l'électrode de réception (E) par commande de la première ou seconde électrode d'émission (S1 ; S2) concernée avec un courant électrique alternatif,
- une capacité électrique changeante peut être constatée à l'aide d'un signal reçu par le biais de l'électrode de réception (E) et ce signal est évalué au moyen d'une unité d'évaluation électronique (5, 5') au moins lors de la fermeture de l'élément de fermeture de véhicule (1) afin de constater la présence d'un obstacle dans le trajet de déplacement de l'élément de fermeture de véhicule (1), et
- les au moins deux électrodes d'émission (S1, S2) sont espacées spatialement l'une de l'autre de sorte qu'elles génèrent dans deux zones de surveillance différentes l'une de l'autre un champ électrique pouvant être influencé par un obstacle avec l'au moins une électrode de réception (E),
**caractérisé en ce que** les deux électrodes d'émission (S1, S2) espacées spatialement l'une de l'autre fonctionnent dans au moins deux modes de fonctionnement différents l'un de l'autre, dans lequel dans un premier mode de fonctionnement, il est évalué s'il y a un obstacle dans une des zones de surveillance, et dans un second mode de fonctionnement, il est évalué en plus dans laquelle des zones de surveillance se trouve un obstacle, dans lequel les deux électrodes d'émission (S1, S2) sont commandées en parallèle et en même temps dans le premier mode de fonctionnement par le biais d'un seul générateur de signal (5.1) avec un courant électrique alternatif et les deux électrodes d'émission (S1, S2) sont commandées dans le second mode de fonctionnement
(a) par le générateur de signal (5.1) de manière décalée dans le temps l'une par rapport à l'autre avec un courant électrique alternatif ou
(b) en opposition de phase.

2. Procédé selon la revendication 1, **caractérisé en ce qu'**il est possible d'alterner entre le premier et le second mode de fonctionnement par le biais d'au moins un commutateur électronique.

3. Procédé selon la revendication 2, **caractérisé en ce que** le commutateur électronique est déclenché par un signal de commutation, qui est généré lors de la détection d'un obstacle potentiel dans la zone de l'ouverture de carrosserie (O) par un dispositif de détection d'obstacle du véhicule (K).

4. Système capacitif anti-pincement pour un véhicule, au moyen duquel un obstacle est détectable dans le trajet de déplacement d'un élément de fermeture de véhicule à fermer actionné par une force extérieure et au moyen duquel il doit être évité qu'un obstacle entre l'élément de fermeture de véhicule se fermant et une structure de véhicule soit pincé dans la zone d'une ouverture de carrosserie, qui est fermée par l'élément de fermeture de véhicule dans une position de fermeture, dans lequel le système anti-pincement comprend au moins ce qui suit :
- au moins deux première et seconde électrodes d'émission (S1, S2) et une électrode de réception (E), dans lequel un champ électrique, qui est influencé par un obstacle de telle sorte qu'une capacité électrique est modifiée de façon mesurable, est généré par une paire formée de la première ou seconde électrode d'émission (S1 ; S2) et de l'électrode de réception (E) par commande de la première ou seconde électrode d'émission (S1 ; S2) concernée avec un courant électrique alternatif, et
- une unité d'évaluation électronique (5, 5'), au moyen de laquelle un signal reçu par le biais d'une électrode de réception (E) peut être évalué de façon à savoir si une capacité électrique a changé en raison d'un obstacle dans le trajet de déplacement de l'élément de fermeture de véhicule (1),
dans lequel les au moins deux électrodes d'émission (S1, S2) sont espacées spatialement l'une de l'autre de sorte qu'elles peuvent générer dans deux zones de surveillance différentes l'une de l'autre un champ électrique pouvant être influencé par un obstacle avec l'au moins une électrode de réception (E),
**caractérisé en ce que**
les deux électrodes d'émission (S1, S2) espacées spatialement l'une de l'autre peuvent fonctionner dans au moins deux modes de fonctionnement différents l'un de l'autre, dans lequel dans un premier mode de fonctionnement, il peut être évalué par l'unité d'évaluation électronique (5, 5') s'il y a un obstacle dans une des zones de surveillance, et dans un second mode de fonctionnement, il peut être évalué en plus par l'unité d'évaluation électronique (5, 5') dans laquelle des zones de surveillance se trouve un obstacle, dans lequel les deux électrodes d'émission (S1, S2) sont commandées en parallèle et en même temps dans le premier mode de fonctionnement par le biais d'un seul générateur de signal (5.1) avec un courant électrique alternatif et les deux électrodes d'émission (S1, S2) sont commandées dans le second mode de fonctionnement
(a) par le générateur de signal (5.1) de manière décalée dans le temps l'une par rapport à l'autre avec un courant électrique alternatif ou
(b) en opposition de phase.

5. Système anti-pincement selon la revendication 4, **caractérisé en ce que** les deux électrodes d'émission (S1, S2) sont prévues au niveau d'arêtes de fermeture (11, 13) espacées l'une de l'autre de l'élément de fermeture de véhicule (1), par le biais desquelles l'élément de fermeture de véhicule (1) repose dans sa position de fermeture respectivement sur la structure de véhicule (F).
